# EUROPÄISCHE PATENTANMELDUNG

(11) **EP 4 811 054 A1**
(43) Veröffentlichungstag der Anmeldung: **23.09.2026**
(21) Anmeldenummer: 25164221.1
(22) Anmeldetag: 17.03.2025
(51) Int. Cl.: G05B 19/042, G05B 19/05, H05K 7/14

(54) **MODULARES STEUERUNGSSYSTEM, VERFAHREN ZUM KONFIGURIEREN UND/ODER BETREIBEN EINES STEUERUNGSSYSTEMS, STEUERUNGSANORDNUNG, ANORDNUNG, COMPUTERPROGRAMMPRODUKT UND COMPUTERLESBARES MEDIUM**

(71) Anmelder: Forschungszentrum Jülich GmbH, 52425 Jülich (DE)
(72) Erfinder: Ehrlich, Christian, 52428 Jülich (DE)
(74) Vertreter: Paul & Albrecht Patentanwälte PartG mbB

(57) **Zusammenfassung**

Die vorliegende Erfindung umfasst ein modulares Steuerungssystem (1), insbesondere zum Steuern von experimentellen Anordnungen, mit
mindestens einer Hauptbaugruppe (3), welche einen Anschluss zur Stromversorgung und eine zentrale Rechnereinheit aufweist,
mindestens einer Funktionsbaugruppe (4-10), welche Ein- und/oder Ausgänge für Signale aufweist, um Geräte, insbesondere Komponenten einer experimentellen Anordnung, anzusteuern,
einer Aufnahmeeinrichtung (2) mit mehreren Aufnahmen (11, 12), welche derart ausgebildet ist, dass die Hauptbaugruppe (3) und mehrere Funktionsbaugruppen (4-10) wahlweise in die Aufnahmen (11, 12) eingesetzt werden können.

## Beschreibung

Die vorliegende Erfindung betrifft ein modulares Steuerungssystem, insbesondere zum Steuern von experimentellen Anordnungen, mit mindestens einer Hauptbaugruppe, welche einen Anschluss zur Stromversorgung und eine zentrale Rechnereinheit aufweist, mindestens einer Funktionsbaugruppe, welche Eingänge und/oder Ausgänge für Signale aufweist, um Geräte, insbesondere Komponenten einer experimentellen Anordnung, anzusteuern, eine Aufnahmeeinrichtung mit mehreren Aufnahmen, welche derart ausgebildet ist, dass die Hauptbaugruppe und mehrere Funktionsbaugruppen wahlweise in die Aufnahmen eingesetzt werden können, wobei Kommunikationsmittel zur kommunikativen Verbindung der Hauptbaugruppe mit mindestens einer, insbesondere mehreren eingesetzten Funktionsbaugruppe(n) vorgesehen sind. Ferner betrifft die Erfindung ein Verfahren zum Konfigurieren und/oder Betreiben eines Steuerungssystems, insbesondere zum Steuern von experimentellen Anordnungen. Außerdem betrifft die Erfindung eine Steuerungsanordnung, eine insbesondere experimentelle Anordnung, ein Computerprogrammprodukt und ein computerlesbares Medium.

Experimentelle Anordnungen, insbesondere verfahrenstechnische Experimente, erfordern häufig verschiedene Komponenten, beispielsweise Messeinrichtungen, Regelungseinrichtungen oder Heizeinrichtungen. Häufig stammen diese von verschiedenen Herstellern und werden durch jeweils individuelle Steuerungsgeräte angesteuert. Diese Steuerungsgeräte benutzen häufig unterschiedliche, von dem jeweiligen Hersteller selbst erstellte Software. Eine Integration in einen Versuchsaufbau ist daher schwierig. Häufig müssen die entsprechenden Komponenten, insbesondere die Steuerungseinrichtung, von dem jeweiligen Hersteller kundenspezifisch angepasst werden, was zu langen Lieferzeiten führt. Auch eine Anpassung der Software ist häufig nur mit einem hohen Aufwand möglich. Eine Weiterverwendung von entsprechenden Komponenten ist dann schwierig, da diese individuell für eine jeweilige spezifische experimentelle Anordnung angepasst sind.

Vor diesem Hintergrund besteht die Aufgabe der vorliegenden Erfindung darin, ein Steuerungssystem und ein Verfahren zum Konfigurieren und/oder Betreiben eines solchen Steuerungssystems bereitzustellen, welches in der Praxis einfach einsetzbar ist.

Diese Aufgabe ist bei einem modularen Steuerungssystem der eingangs genannten Art dadurch gelöst, dass jede Hauptbaugruppe ausgebildet ist, über die Kommunikationsmittel eigenständig zu erkennen, welche Funktionsbaugruppen in die Aufnahmeeinrichtung eingesetzt sind.

Der Erfindung liegt damit die grundsätzliche Überlegung zugrunde, ein weitgehend individuell konfigurierbares Steuerungssystem zu schaffen, welches eine Hauptbaugruppe aufweist, die eine zentrale Rechnereinheit umfasst. Daneben können je nach spezifischer Anforderung bestimmte Funktionsbaugruppen ausgewählt und verwendet werden, die zur Ansteuerung von Komponenten oder zum Empfang von Signalen ausgebildet sind. Die Hauptbaugruppe und die Funktionsbaugruppen können dabei in eine entsprechende Aufnahmeeinrichtung eingesetzt werden. Nach dem Aktivieren der Stromversorgung ist die Hauptbaugruppe eigenständig in der Lage, zu erkennen, welche Funktionsbaugruppen eingesetzt sind. Dadurch entfällt ein aufwändiges Konfigurieren der für die jeweilige insbesondere experimentelle Anordnung konfigurierten Steuerungsanordnung. Somit entsteht beim Konfigurieren einer Steuerungsanordnung eine erhebliche Zeitersparnis für einen Benutzer. Außerdem werden Fehler, die bei einer manuellen Eingabe der einzelnen Komponenten entstehen können, vermieden. Im Ergebnis ergibt sich dadurch eine höhere Zuverlässigkeit. Außerdem ist ein solches modulares Steuerungssystem vielseitig einsetzbar, sodass eine Änderung der experimentellen Anordnung, die mittels eines solchen Steuerungssystems gesteuert wird, auf einfache Weise möglich ist.

Dazu korrespondierend ist die der Erfindung zugrundeliegende Aufgabe bei einem Verfahren, insbesondere einem computergestützten Verfahren, zum Konfigurieren und/oder Betreiben eines Steuerungssystems gelöst, welches die folgenden Schritte umfasst:
- Bereitstellen eines modularen Steuerungssystems gemäß der vorliegenden Erfindung;
- Einsetzen der Hauptbaugruppe und der ausgewählten Funktionsbaugruppen in entsprechende Aufnahmen der Aufnahmeeinrichtung:
- Einschalten der Stromversorgung;
- Selbstständiges Erkennen durch die Hauptbaugruppe, welche Funktionsbaugruppen in die Aufnahmeeinrichtung eingesetzt sind.

In bevorzugter Ausgestaltung kann das Verfahren derart ausgestaltet sein, dass den einzelnen Eingängen und Ausgängen der Funktionsbaugruppe selbstständig Adressen zugewiesen werden.

In weiterer Ausgestaltung des modularen Steuerungssystems kann die Hauptbaugruppe einen Anschluss für eine Mensch-Maschine-Schnittstelle aufweisen. Das Steuerungssystem kann eine Mensch-Maschine-Schnittstelle umfassen, die mit der Hauptbaugruppe verbunden oder verbindbar ist. Konkret kann die Mensch-Maschine-Schnittstelle ein graphisches Display, insbesondere einen Monitor, und/oder Eingabemittel, insbesondere eine Tastatur und/oder eine Maus, umfassen. Durch eine derartige Mensch-Maschine-Schnittstelle kann ein Benutzer in gewohnter Weise Eingaben vornehmen bzw. Informationen angezeigt bekommen.

Das erfindungsgemäße Verfahren kann dadurch gekennzeichnet sein, dass über eine solche Mensch-Maschine-Schnittstelle Eingaben gemacht werden und insbesondere durch einen Benutzer Programme erstellt werden. Hierbei kann es sich um ein sogenanntes Drag and Drop-System handeln, welches ein intuitives Verknüpfen von Ein- und Ausgängen der Funktionsbaugruppen ermöglicht. Bevorzugt kann dadurch eine Ablaufsteuerung erstellt werden. Dadurch können auf einfache Weise Steuerungsaufgaben programmiert werden. Anders ausgedrückt kann das erfindungsgemäße Verfahren auch das Programmieren des Steuerungssystems umfassen, wobei auf den einzelnen Ausgängen und Eingängen der Funktionsbaugruppen zugewiesenen Adressen zurückgegriffen wird und insbesondere entsprechende Zuordnungen vorgenommen werden. Konkret kann das Programmieren mittels Funktionsplan, Kontaktplan oder Anweisungsliste erfolgen.

Das modulare Steuerungssystem kann genau eine Hauptgruppe umfassen. Die Hauptbaugruppe kann ausgebildet sein, mit einem Wechselstrom von 230 V und/oder mit einem Drehstrom von 400 V versorgt zu werden. Möglich ist auch, dass je nach dem erforderlichen Strombedarf insbesondere der eingesetzten Funktionsbaugruppen wahlweise eine Hauptbaugruppe ausgewählt werden kann, die entweder mit einem Wechselstrom von 230 V oder mit einem Drehstrom von 400 V versorgt werden kann. Das bedeutet, dass das Steuerungssystem zwei verschiedene Hauptbaugruppen umfassen kann, wobei je nach erforderlichem Strombedarf eine der beiden ausgewählt und in die Aufnahmeeinrichtung eingesetzt wird. Jede Hauptbaugruppe kann einen Schalter zum Ein- und Ausschalten der Hauptbaugruppe aufweisen. Hierbei kann es sich um einen zentralen Schalter handeln, der zum Ein- oder Ausschalten der Stromversorgung verwendet werden kann.

Zur Stromversorgung der Funktionsbaugruppen kann jede Hauptbaugruppe Stromversorgungsmittel aufweisen. Diese können mindestens ein Netzteil, insbesondere mehrere Netzteile umfassen. Dieser Ausgestaltung liegt die Überlegung zugrunde, dass die Hauptbaugruppe gleichzeitig die Stromversorgung für die Funktionsbaugruppen bereitstellen kann. Dazu kann die Hauptbaugruppe ein Netzteil oder mehrere Netzteile aufweisen, welche eine oder unterschiedliche Spannungen zur Stromversorgung der Funktionsbaugruppen bereitstellen können. Beispielsweise kann es sich hier um Gleichspannungen handeln. Möglich ist auch, dass mehrere, insbesondere genau vier, Netzteile bzw. Spannungsquellen vorhanden sind. Konkret können diese Netzteile ausgebildet sein, Versorgungsspannungen, insbesondere Gleichspannungen, von +5 V, +15 V, -15 V und 24 V bereitzustellen. Dementsprechend kann vorgesehen sein, dass die Funktionsbaugruppen nicht über eigene Netzteile verfügen, sondern lediglich Anschlussmittel für die Verbindung mit der von der Hauptbaugruppe bereitgestellten Stromversorgung ausweisen.

Insbesondere an einer Rückseite kann jede Hauptbaugruppe eine Kommunikationsschnittstelle aufweisen. Diese kann zur Verbindung mit den Kommunikationsmitteln ausgebildet sein, um Steuersignale an Funktionsbaugruppen zu senden und/oder Signale von diesen zu Empfangen.

Dementsprechend kann bei dem erfindungsgemäßen Verfahren die Hauptbaugruppe insbesondere über die Kommunikationsschnittstelle Signale von den Funktionsbaugruppen empfangen bzw. Steuersignale an diese senden.

In weiterer Ausgestaltung kann jede Funktionsbaugruppe eine eigene Rechnereinrichtung aufweisen. Dieser Ausgestaltung liegt die Überlegung zugrunde, dass die jeweilige Steuerungsaufgabe von der jeweiligen Funktionsbaugruppe, die mit der entsprechenden, anzusteuernden Komponente verbunden ist, weitgehend eigenständig durchgeführt wird. Dazu kann bei dem erfindungsgemäßen Verfahren die Kommunikation zwischen den Funktionsbaugruppen und der Hauptbaugruppe ereignisbasiert erfolgen. Das bedeutet, dass kein permanenter Datenaustausch zwischen der Hauptbaugruppe und den Funktionsbaugruppen vorgesehen ist, sondern nur dann eine Kommunikation stattfindet, wenn ein Ereignis dies erfordert. Anders ausgedrückt werden solange keine Daten zwischen der jeweiligen Funktionsbaugruppe und der Hauptbaugruppe gesendet, wie keine Änderung des Zustands oder neue Befehle erforderlich sind.

Mindestens eine Funktionsbaugruppe kann digitale Eingänge und/oder Ausgänge aufweisen. Dabei kann es sich um eine gemischte Baugruppe handeln, welche sowohl Eingänge, als auch Ausgänge aufweist. Möglich sind auch Funktionsbaugruppen, welche nur Eingänge oder Ausgänge aufweisen. Mindestens eine Funktionsbaugruppe kann in gleicher Weise analoge Eingänge und/oder Ausgänge aufweisen. Möglich ist auch, dass mindestens eine Funktionsbaugruppe eine Kommunikationskarte aufweist, welche insbesondere ausgebildet ist, mit einer RS232- und/oder RS485-Schnittstelle zu interagieren. Anders ausgedrückt kann mindestens eine Funktionsbaugruppe eine derartige Schnittstelle aufweisen, um mit entsprechenden Komponenten insbesondere einer experimentellen Anordnung zu kommunizieren. Derartige serielle Schnittstellen werden standardmäßig in vielen Geräten eingesetzt.

Eine RS232-Schnittstelle kann beispielsweise eine 9-polige Steckverbindung aufweisen. Eine RS485-Schnittstelle, welche auch als ElA-485-Schnittstelle bezeichnet wird, ist ebenfalls ein üblicher Industriestandard für eine Schnittstelle für die asynchrone serielle Datenübertragung. Eine solche Funktionsbaugruppe bzw. Kommunikationskarte kann ausgebildetes sein, zu erkennen, welche Schnittstelle (RS232 oder RS485) gewünscht ist. Eine Umschaltung kann über einen Adapter, insbesondere über einen 15-poligen Adapter, bevorzugt über einen 15-poligen D-Sub-Adapter erfolgen, welcher auf die Funktionsbaugruppe gesteckt wird. Auf der anderen Seite des Adapters kann eine Schnittstelle vorhanden sein, insbesondere eine 9-polige Schnittstelle.

Möglich ist auch, dass mindestens eine Funktionsbaugruppe Steuermittel zur Ansteuerung von Heizelementen aufweist. Gerade bei verfahrenstechnischen Experimenten spielen Heizelemente, welche insbesondere ein Fluid auf eine bestimmte Temperatur erwärmen können, eine besondere Rolle. Diese können beispielsweise widerstandsbeheizt sein und dementsprechend hohe Stromstärken benötigen. Das bedeutet, dass eine derartige Funktionsbaugruppe in der Lage sein kann, hohe Leistungen zu steuern.

Mindestens eine Funktionsbaugruppe, insbesondere jede Funktionsbaugruppe kann/können als Einschubkarte ausgebildet sein. Dementsprechend können die Aufnahmen der Aufnahmeeinrichtung als Einschübe ausgebildet sein. Das bedeutet, dass zum Konfigurieren eines Steuerungssystems die ausgewählten Funktionsbaugruppen auf einfache Weise in einen entsprechenden Einschub eingeschoben werden können. Konkret kann die Aufnahmeeinrichtung jeder Aufnahme zugeordnet und mindestens eine Führungsschiene, insbesondere zwei einander gegenüberliegende Führungsschienen zum Einschieben der Funktionsbaugruppen aufweisen. Jede Hauptbaugruppe und/oder jede Funktionsbaugruppe kann eine Frontplatte aufweisen, welche insbesondere eben und/oder aus einem metallischen Werkstoff ausgebildet ist, sodass, im eingesetzten Zustand, die Frontplatten der Hauptbaugruppe und der eingesetzten Funktionsbaugruppen die Aufnahmeeinrichtung zu einer Vorderseite hin abschließen.

Jede Funktionsbaugruppe kann eine Kommunikationsschnittstelle aufweisen, welche zur Verbindung mit den Kommunikationsmitteln ausgebildet ist, um Steuersignale an die Hauptbaugruppe zu senden und/oder Steuersignale von dieser zu empfangen. Die Kommunikationsschnittstellen sowohl der Funktionsbaugruppe, als auch der Hauptbaugruppe können dabei als Steckverbinder ausgebildet sein, welche beim Einsetzten in korrespondierende Gegenverbinder, welche in der Aufnahmeeinrichtung angeordnet sein können, in Eingriff kommen.

Die Aufnahmeeinrichtung kann als Rack, insbesondere als 19 Zoll-Rack, bevorzugt nach EIA 310-D (1992) oder IEC 60297-3 (in der am Anmeldetag gültigen Fassung) oder nach DIN 41494-1:1974-09, ausgebildet sein. Hierbei handelt es sich Standard-Aufnahmeeinrichtungen für elektrotechnische Komponenten.

Wenn die Aufnahmen der Aufnahmeeinrichtung als Einschübe ausgebildet sind, kann jede Aufnahme eine untere Führungsschiene und eine obere Führungsschiene aufweisen. Entlang derartiger Führungsschienen können die Hauptbaugruppe und die Funktionsbaugruppen in die Aufnahmeeinrichtung eingeschoben werden. Die Aufnahmen für die Funktionsbaugruppen können dabei identisch ausgebildet sein. Die Aufnahme für die Hauptbaugruppe kann andere Abmessungen aufweisen als die Aufnahmen für die Funktionsbaugruppen. Dadurch kann ein fehlerhaftes Einsetzen vermieden werden.

Die Kommunikationsmittel können in die Aufnahmeeinrichtung integriert sein. Konkret können die Kommunikationsmittel jeder Aufnahme zugeordnet mindestens einen Steckverbinder umfassen. Bevorzugt sind die Steckverbinder in die Aufnahmeeinrichtung eingebaut und an einer Rückwand innenseitig angeordnet. Bevorzugt kommen beim Einsetzen in die Aufnahmeeinrichtung die entsprechenden Kommunikationsschnittstellen der Baugruppen in Eingriff mit den Steckverbindern.

Bevorzugt weisen die Kommunikationsmittel mindestens eine Busverbindung auf. Insbesondere können sie zwei Busverbindungen aufweisen, die sich insbesondere zwischen den Aufnahmen der Hauptbaugruppe und der Aufnahmen der Funktionsbaugruppen erstrecken.

In weiterer Ausgestaltung kann eine Busverbindung als Signalbus dienen. Diese kann sich für die Aufnahme für die Hauptbaugruppe zu den Aufnahmen sämtlicher Funktionsbaugruppen erstrecken. Anders ausgedrückt, kann es sich hierbei um eine in Serie geschaltete Busverbindung handeln, sodass ein Signal, welches beispielsweise von der Hauptbaugruppe ausgegeben wird, bei sämtlichen Funktionsbaugruppen ankommt. Insbesondere kann die Signalbusverbindung als 8-bit-Busverbindung ausgebildet sein. Sie kann dazu ausgebildet sein und eingesetzt werden, Steuer- und Regelbefehle von der Hauptbaugruppe an die Funktionsbaugruppen und umgekehrt zu übermitteln.

Eine Busverbindung kann als Steuerbusverbindung ausgebildet sein. Die Steuerbusverbindung kann eine Vielzahl von Verbindungen umfassen, die sich jeweils von der Aufnahme für die Hauptbaugruppe zu einer Aufnahme für eine Funktionsbaugruppe erstrecken. Das bedeutet, dass ausgehend von der Hauptbaugruppe jede Aufnahme für eine Funktionsbaugruppe gesondert eigenständig angesteuert werden kann. Praktisch existiert so eine Parallelschaltung, die derart eingesetzt werden kann, dass von der Hauptbaugruppe ausgehend mit jeder individuellen Funktionsbaugruppe einzeln kommuniziert werden kann.

Konkret kann die Steuerbusverbindung als 4-bit-Busverbindung ausgebildet sein. Ein Bit kann dabei ausgebildet sein, eine Funktionsbaugruppe dazu aufzufordern, ihre aktuellen Daten an die Hauptbaugruppe zu senden. Dementsprechend kann bei einem erfindungsgemäßen Verfahren die Hauptbaugruppe eine bestimmte Funktionsbaugruppe über dieses Bit dazu auffordern, ihre aktuellen Daten an die Hauptbaugruppe zu senden. Ein weiteres Bit kann dazu ausgebildet sein, eine eingesetzte Funktionsbaugruppe dazu aufzufordern, Daten von der Hauptbaugruppe zu empfangen. Anders ausgedrückt kann, wenn eine Funktionsbaugruppe Daten von der Hauptbaugruppe empfangen soll, ein Bit diese dazu auffordern. Ein weiteres Bit kann dazu ausgebildet sein, derartige Anweisungen zu quittieren, d. h. zu bestätigen. Schließlich kann ein Bit dazu ausgebildet sein, ein Fehlverhalten einer Funktionsbaugruppe an die Hauptbaugruppe zu übermitteln. Dadurch, dass die Steuerbusverbindung jede einzelne Funktionsbaugruppe einzeln mit der Hauptbaugruppe verbindet, kann so eine eindeutige Zuordnung stattfinden.

Die Aufnahmeeinrichtung kann ferner Stromversorgungsmittel aufweisen, welche ausgebildet sind, eingesetzte Funktionsbaugruppen mit Strom zu versorgen. Diese können eine Stromleitung umfassen, welche von einer Aufnahme für die Hauptbaugruppe zu den Aufnahmen für die Funktionsbaugruppen verläuft.

Grundsätzlich ist vorgesehen, dass das modulare Steuerungssystem nicht montiert ist, d. h. die Aufnahmeeinrichtung und die Baugruppen als separate Komponenten zur Verfügung stehen, sodass ein Benutzer je nach zu steuernder Anordnung die benötigten Komponenten auswählen kann. Anders ausgedrückt ist das Steuerungssystem frei konfigurierbar. Für den Betrieb kann auch vorgesehen sein, dass das Steuerungssystem in einem montierten Zustand vorliegt. In diesem Fall sind eine Hauptbaugruppe und mindestens eine, insbesondere mehrere Funktionsbaugruppen in die Aufnahmeeinrichtung eingesetzt.

Das Steuerungssystem kann ausgebildet sein, auch kaskadiert betrieben zu werden. Das bedeutet, dass bei einer entsprechend großen Anordnung, insbesondere einer experimentellen Anordnung, mehrere Steuerungssysteme wie zuvor beschrieben miteinander verschaltet werden können. Dazu können entsprechende Verbindungsmittel zur kommunikativen Verbindung der Steuerungssysteme miteinander vorgesehen sein. Durch eine solche Kombination mehrerer Steuerungssysteme können auch Anordnungen, die eine Vielzahl von Eingängen oder Ausgängen für Signale erfordern, gesteuert werden.

Dementsprechend ist Gegenstand der Erfindung auch eine Steuerungsanordnung umfassend mehrere Steuerungssysteme wie zuvor beschrieben. Dabei können die Steuerungssysteme kommunikativ miteinander verbunden sein. Die Aufnahmeeinrichtungen der Steuerungssysteme können dabei in einem gemeinsamen Schaltschrank untergebracht sein. Bevorzugt sind die Aufnahmeeinrichtungen der Steuerungssysteme in dem gemeinsamen Schaltschrank benachbart zueinander, insbesondere direkt übereinander untergebracht.

Die der Erfindung zugrundeliegende Aufgabe ist ferner gelöst durch eine Anordnung, insbesondere eine experimentelle Anordnung, umfassend
- ein modulares Steuerungssystem gemäß der vorliegenden Erfindung;
- Komponenten, insbesondere experimentelle Komponenten, die mit dem modularen Steuerungssystem, insbesondere einer oder mehreren Funktionsbaugruppen verbunden sind, sodass das Steuerungssystem die Komponenten der Anordnung steuern kann.

Bei den Komponenten kann es sich beispielsweise um Sensorelemente, beispielsweise um Temperatursensoren, bevorzugt Thermoelemente und/oder Widerstandsthermometer, Drucksensoren, um Einrichtungen zur Messung von einer Konzentration, um Durchflusssensoren und/oder, um Lichtsensoren, und/oder um Ventile, und/oder um Schalteinrichtungen, und/oder um Heizeinrichtungen und/oder um Füllstandsensoren und/oder um Zustandssensoren handeln.

Ferner ist die der Erfindung zugrundeliegende Aufgabe gelöst durch ein Computerprogrammprodukt umfassend Befehle, die bewirken, dass das erfindungsgemäße modulare Steuerungssystem und/oder die erfindungsgemäße Steuerungsanordnung und/oder die erfindungsgemäße insbesondere experimentelle Anordnung die Verfahrensschritte des erfindungsgemäßen Verfahrens ausführt.

Außerdem ist die der Erfindung zugrundeliegende Aufgabe gelöst durch ein computerlesbares Medium, auf dem ein solches Computerprogrammprodukt gespeichert ist.

Für die weitere Ausgestaltung der Erfindung wird auf die Unteransprüche und auf die nachstehende Erläuterung eines Ausführungsbeispiels unter Bezugnahme auf die Zeichnung verwiesen. In der Zeichnung zeigt:
- Figur 1: ein modulares Steuerungssystem gemäß der vorliegenden Erfindung, wobei in die Aufnahmeeinrichtung eine Hauptbaugruppe und mehrere Funktionsbaugruppen eingesetzt sind, in einer Vorderansicht;
- Figur 2: die Aufnahmeeinrichtung von einer Vorderseite ohne eingesetzte Hauptbaugruppe und Funktionsbaugruppen;
- Figur 3: die Rückseite der Aufnahmeeinrichtung mit demontierter Abdeckung;
- Figur 4: die Vorderseite der Hauptbaugruppe aus Figur 1 als einzelne Komponente; und
- Figur 5: ein Beispiel für eine experimentelle Anordnung, welche mit einem Steuerungssystem gemäß der vorliegenden Erfindung gesteuert werden kann in einer schematischen Darstellung.

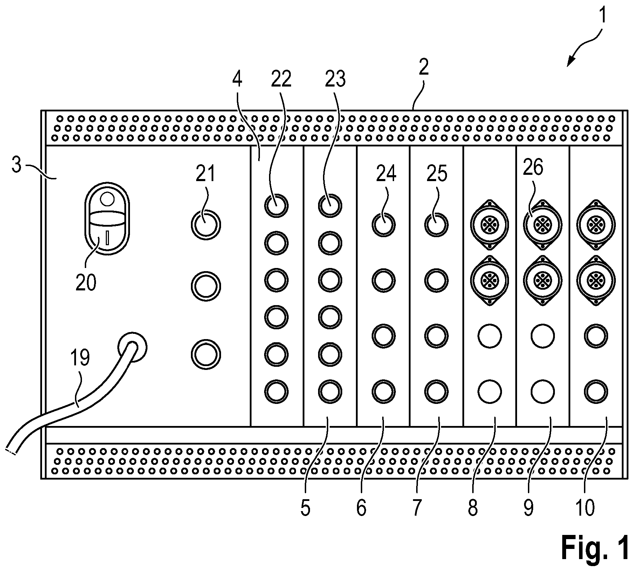

Die Figur 1 zeigt ein modulares Steuerungssystem 1 gemäß der vorliegenden Erfindung in einem montierten Zustand. Konkret umfasst das modulare Steuerungssystem eine Aufnahmeeinrichtung 2, eine Hauptbaugruppe 3 und mehrere Funktionsbaugruppen 4-10.

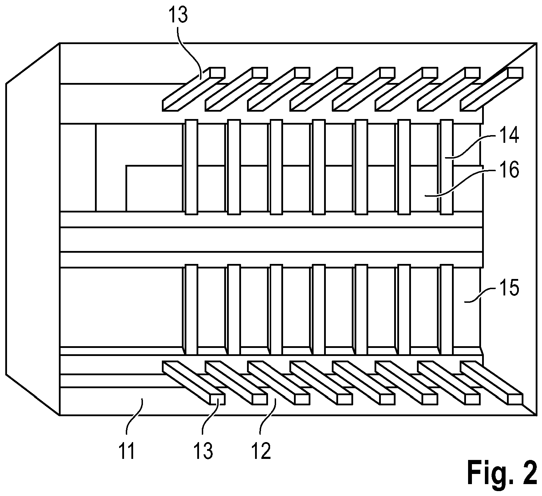

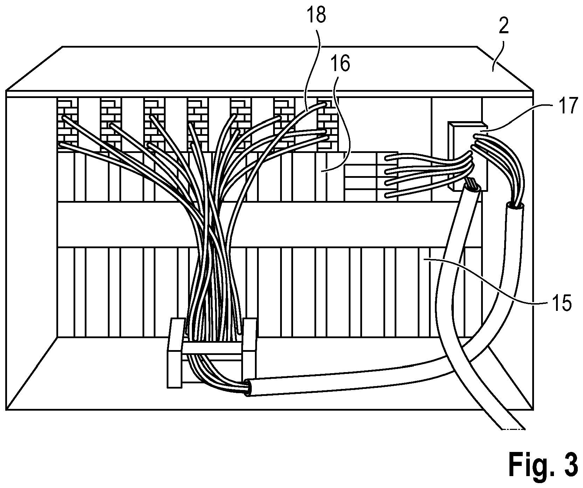

Die Aufnahmeeinrichtung 2, welche als einzelne Komponente in den Figuren 2 und 3 dargestellt ist, ist vorliegend als 19-Zoll-Rack ausgebildet und umfasst eine Aufnahme 11 für die Hauptbaugruppe 3 und, in der Figur 1 rechts danebenliegend, sieben Aufnahmen 12 für Funktionsbaugruppen 4-10. Die Aufnahme 11 für die Hauptbaugruppe 3 ist dabei deutlich breiter ausgebildet als die Aufnahmen 12 für die Funktionsbaugruppen 4-10, welche identisch ausgebildet sind. Jede Aufnahme 11, 12 weist zwei Führungsschienen 13 auf, wobei jeweils eine Führungsschiene 13 an einer Oberseite und eine Führungsschiene 13 an einer Unterseite angeordnet sind. Dementsprechend sind die Aufnahmen 11, 12 der Aufnahmeeinrichtung 2 als Einschübe ausgebildet, sodass die Hauptbaugruppe 3 und die Funktionsbaugruppen 4-10 von einer Vorderseite in die Aufnahmeeinrichtung 2 eingeschoben werden können.

Ferner weist die Aufnahmeeinrichtung 2 Kommunikationsmittel auf, die, wie in Figur 2 erkennbar ist, an einer Rückseite der Aufnahmeeinrichtung 2 angeordnet sind. Diese dienen der kommunikativen Verbindung der Hauptbaugruppe 3 mit eingesetzten Funktionsbaugruppen 4-10. Konkret umfassen die Kommunikationsmittel jeder Aufnahme 12 für eine Funktionsbaugruppe 4-10 zugeordnet zwei Steckverbinder 14, die übereinander angeordnet sind. Jeder Steckverbinder 14 weist eine Vielzahl von Kontakten auf. Beim Einsetzen der Funktionsbaugruppen 4-10 in die Aufnahmeeinrichtung 2 kommen die Funktionsbaugruppen 4-10 in Eingriff mit den Steckverbindern 14. Dazu weisen die Funktionsbaugruppen 4-10 an ihrer Rückseite entsprechende korrespondierende Steckverbinder auf.

Der Aufnahme 11 für die Hauptbaugruppe 3 ist ebenfalls ein Steckverbinder 14 in einem unteren Bereich zugeordnet.

Die Kommunikationsmittel weisen zwei Busverbindungen 15, 16 auf, die sich zwischen der Aufnahme 11 für die Hauptbaugruppe 3 und den Aufnahmen 12 für die Funktionsbaugruppen 4-10 erstrecken. Konkret dient eine Busverbindung 15 als Signalbus und erstreckt sich von der Aufnahme 11 für die Hauptbaugruppe 3 in Aufnahmen 12 in sämtliche Funktionsbaugruppen 4-10. Konkret ist die Signalbus-Verbindung 15 als 8-bit-Busverbindung ausgebildet und dient dazu, Steuer- und Regelbefehle von der Hauptbaugruppe 3 an die Funktionsbaugruppen 4-10 und umgekehrt zu übermitteln.

Die andere Busverbindung ist als Steuerbusverbindung 16 ausgebildet und erstreckt sich jeweils von der Aufnahme 11 für die Hauptbaugruppe 3 zu jeder Aufnahme 12 für eine Funktionsbaugruppe 4-10. Konkret ist die Steuerbusverbindung 16 als 4-bit-Busverbindung ausgebildet. Ein Bit ist dabei ausgebildet, eine Funktionsbaugruppe 4-10 dazu aufzufordern, ihre aktuellen Daten an die Hauptbaugruppe 3 zu senden. Ein weiteres Bit ist dazu ausgebildet, eine eingesetzte Funktionsbaugruppe 4-10 dazu aufzufordern, Daten von der Hauptbaugruppe 3 zu empfangen. Außerdem ist ein weiteres Bit dazu ausgebildet, derartige Anweisungen zu quittieren. Schließlich ist ein viertes Bit ausgebildet, ein Fehlverhalten einer Funktionsbaugruppe 4-10 an die Hauptbaugruppe 3 zu übermitteln. Dadurch, dass separate Verbindungen von der Aufnahme 11 für die Hauptbaugruppe 3 zu jeder Aufnahme 12 für eine Funktionsbaugruppe 4-10 verlaufen, ist eine eindeutige Zuordnung der Signale, welche über die Steuerbusverbindung 16 übermittelt werden, möglich.

Die Aufnahmeeinrichtung 2 weist ferner Stromversorgungsmittel auf, welche ausgebildet sind, eingesetzte Funktionsbaugruppen 4-10 mit Strom zu versorgen. Dazu ist in einem oberen Bereich an der Rückseite der Aufnahme 11 für die Hauptbaugruppe 3 ein Stromversorgungs-Steckverbinder 17 vorgesehen, welcher eine Mehrzahl an Kontakten aufweist. Ausgehend von diesem Stromversorgungs-Steckverbinder 17 verlaufen Stromleitungen von der Aufnahme 11 für die Hauptbaugruppe 3 zu jeder Aufnahme 12 für eine Funktionsbaugruppe 4-10. Der Verlauf der Stromleitung 18 ist in der Figur 3, welche die Rückseite der Aufnahmeeinrichtung 2 von hinten zeigt, ersichtlich. Diese münden in einen oberen Bereich der oberen Steckverbinder 14 der Aufnahmen 12 für Funktionsbaugruppen 4-10.

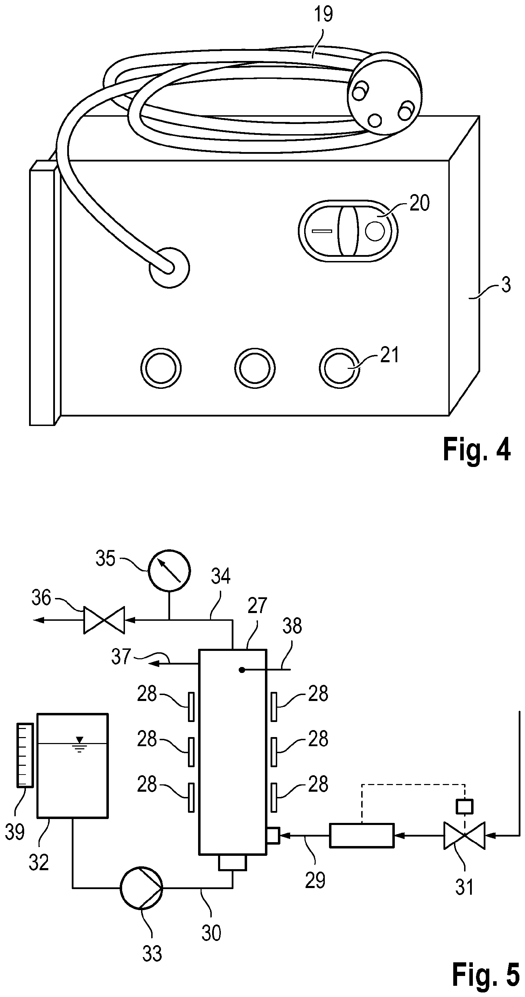

Eine beispielhafte Hauptbaugruppe 3 ist in der Figur 4 dargestellt. Diese ist ausgebildet, mit einem Wechselstrom von 230 V versorgt zu werden. Konkret ist dazu ein Stromkabel 19 an einer Vorderseite der Hauptbaugruppe 3 angeschlossen. Ferner weist die Hauptbaugruppe 3 einen Schalter 20 zum Ein- und Ausschalten der Hauptbaugruppe auf. Außerdem weist die Hauptbaugruppe 3 an einer Vorderseite einen Anschluss 21 für eine Mensch-Maschine-Schnittstelle auf. Die Hauptbaugruppe 3 enthält ferner nicht im Detail dargestellte Netzteile zur Stromversorgung der Funktionsbaugruppen 4-10. Dazu weist die Hauptbaugruppe 3 an einer Rückseite entsprechende Steckverbinder auf, welche mit den Steckverbindern 14 der Aufnahmeeinrichtung 2 in Eingriff gebracht werden können, wenn die Hauptbaugruppe 3 in die entsprechende Aufnahme 11 eingeschoben wird.

Die insgesamt sieben Funktionsbaugruppen 4-10 sind unterschiedlich ausgebildet und haben unterschiedliche Anschlüsse. Die Funktionsbaugruppe 4-10, welche in der Figur 1 direkt neben der Hauptbaugruppe 3 angeordnet ist, besitzt insgesamt sechs Digital-Eingänge 22. Die daneben angeordnete Funktionsbaugruppe 5 weist insgesamt sechs Digital-Ausgänge 23 auf.

Bei den daneben angeordneten Funktionsbaugruppen 6, 7 handelt es sich um Analog-Baugruppen, wobei die Funktionsbaugruppe 6 vier Analog-Eingänge 24 und die Funktionsbaugruppe 7 vier Analog-Ausgänge 25 aufweist.

Die rechts in der Aufnahmeeinrichtung angeordneten Funktionsbaugruppen 8, 9, 10 sind identisch ausgebildet und weisen jeweils zwei Heizelement-Anschlüsse 26 zum Steuern bzw. Versorgen von Heizelementen auf. An ihren Rückseiten weisen die Funktionsbaugruppen 4-10 jeweils Verbindungsmittel in Form von Steckverbindern korrespondierend zu den Steckverbindern 14 der Aufnahmeeinrichtung 2 auf.

Die Figur 5 zeigt ein einfaches Beispiel für eine experimentelle Anordnung, welche einen Reaktor 27 und mehrere schematisch dargestellte Heizelemente 28 aufweist. In den Reaktor 27, welcher einen Reaktorinnenraum aufweist, in welchem eine chemische Reaktion stattfindet, mündet eine Zuluftleitung 29 und eine Eduktleitung 30. Die Zuluftleitung 29 besitzt ein Regelventil 31 zur Steuerung der Durchflussmenge. Die Eduktleitung 30 geht von einem Tank 32 aus, in welchem ein Edukt gelagert ist. Um dieses Edukt von dem Tank 32 durch die Eduktleitung 30 in den Reaktor 27 zu transportieren, ist eine Zuführpumpe 33 in der Eduktleitung 30 vorgesehen.

Obenseitig geht vom Reaktor eine Abluftleitung 34 aus, in der ein Drucksensor 35 und ein Regelventil 36 vorgesehen sind. Ferner geht an einer Oberseite vom Reaktor eine Produktleitung 37 auf, durch welche ein in der chemischen Reaktion im Reaktor 27 entstehendes Produkt abgeleitet werden kann. In dem Reaktor 27 ist ferner ein Temperatursensor beispielsweise in Form eines Thermoelements 38 vorgesehen.

Die einzelnen Komponenten können nun mit modularen Steuerungssystemen 1, wie es in der Figur 1 dargestellt ist, verbunden, und von diesem angesteuert werden. Beispielsweise können der Drucksensor 35, ein Füllstandsensor 39 zur Erfassung des Füllstands in dem Tank 32 und das Thermoelement 38 mit der Funktionsbaugruppe 6, welche mehrere Analog-Eingänge 24 aufweist, verbunden sein. Die Heizelemente 28 können durch die Funktionsbaugruppen 8, 9 und 10 angesteuert und mit Strom versorgt werden. Die Zuführpumpe 33 kann mit einem Digital-Ausgang 23 der Funktionsbaugruppe 5 verbunden sein, sodass sie wahlweise eingeschaltet werden kann. Die beiden Regelventile 31, 36 können mit einem Analog-Ausgang 25 der Funktionsbaugruppe 7 verbunden sein. Somit kann das modulare Steuerungssystem gemäß der vorliegenden Erfindung flexibel verwendet werden, um verschiedenartige experimentelle Anordnungen und die darin enthaltenen Komponenten bevorzugt Herstellerunabhängig zu steuern.

### Bezugszeichenliste

- 1: modulares Steuerungssystem
- 2: Aufnahmeeinrichtung
- 3: Hauptbaugruppe
- 4-10: Funktionsbaugruppe
- 11: Aufnahme für Hauptbaugruppe
- 12: Aufnahme für Funktionsbaugruppe
- 13: Führungsschiene
- 14: Steckverbinder
- 15: Signalbus-Verbindung
- 16: Steuerbus-Verbindung
- 17: Stromversorgungs-Steckverbinder
- 18: Stromleitung
- 19: Stromkabel
- 20: Schalter
- 21: Anschluss
- 22: Digital-Eingang
- 23: Digital-Ausgang
- 24: Analog-Eingang
- 25: Analog-Ausgang
- 26: Heizelement-Anschluss
- 27: Reaktor
- 28: Heizelement
- 29: Zuluftleitung
- 30: Eduktleitung
- 31: Regelventil
- 32: Tank
- 33: Zuführpumpe
- 34: Abluftleitung
- 35: Drucksensor
- 36: Regelventil
- 37: Produktleitung
- 38: Thermoelement
- 39: Füllstandsensor

## Patentansprüche

1. Modulares Steuerungssystem (1), insbesondere zum Steuern von experimentellen Anordnungen, mit
mindestens einer Hauptbaugruppe (3), welche einen Anschluss zur Stromversorgung und eine zentrale Rechnereinheit aufweist,
mindestens einer Funktionsbaugruppe (4-10), welche Ein- und/oder Ausgänge für Signale aufweist, um Geräte, insbesondere Komponenten einer experimentellen Anordnung, anzusteuern,
einer Aufnahmeeinrichtung (2) mit mehreren Aufnahmen (11, 12), welche derart ausgebildet ist, dass die Hauptbaugruppe (3) und mehrere Funktionsbaugruppen (4-10) wahlweise in die Aufnahmen (11, 12) eingesetzt werden können,
wobei Kommunikationsmittel zur kommunikativen Verbindung der Hauptbaugruppe (3) mit mindestens einer, insbesondere mehreren eingesetzten Funktionsbaugruppe(n) (4-10) vorgesehen sind,
**dadurch gekennzeichnet, dass** jede Hauptbaugruppe (3) ausgebildet ist, über die Kommunikationsmittel eigenständig zu erkennen, welche Funktionsbaugruppen (4-10) in die Aufnahmeeinrichtung (2) eingesetzt sind.

2. Steuerungssystem (1) nach Anspruch 1, **dadurch gekennzeichnet, dass** jede Hauptbaugruppe (3) einen Anschluss (21) für eine Mensch-Maschine-Schnittstelle aufweist, wobei, insbesondere, das Steuerungssystem (1) eine Mensch-Maschine-Schnittstelle umfasst, die mit der Hauptbaugruppe (3) verbunden oder verbindbar ist, wobei, bevorzugt, die Mensch-Maschine-Schnittstelle ein graphisches Display, insbesondere einen Monitor, und/oder Eingabemittel, insbesondere eine Tastatur und/oder eine Maus, umfasst.

3. Steuerungssystem (1) nach einem der vorherigen Ansprüche, **dadurch gekennzeichnet, dass** jede Hauptbaugruppe (3) ausgebildet ist, mit einem Wechselstrom von 230 V und/oder mit einem Drehstrom von 400 V versorgt zu werden, und/oder
**dass** jede Hauptbaugruppe (3) einen Schalter (20) zum Ein- und Ausschalten der Hauptbaugruppe (3) aufweist, und/oder
**dass** jede Hauptbaugruppe (3) Stromversorgungsmittel zur Stromversorgung der Funktionsbaugruppen (4-10) aufweist, wobei, insbesondere, die Stromversorgungmittel mindestens ein Netzteil umfassen, und/oder
**dass** jede Hauptbaugruppe (3) insbesondere an einer Rückseite eine Kommunikationsschnittstelle aufweist, welche zur Verbindung mit den Kommunikationsmitteln ausgebildet ist, um Steuersignale an Funktionsbaugruppen (4-10) zu senden und/oder Signale von diesen zu empfangen.

4. Steuerungssystem (1) nach einem der vorherigen Ansprüche, **dadurch gekennzeichnet, dass** jede Funktionsbaugruppe (4-10) eine eigene Rechnereinrichtung aufweist, und/oder
**dass** mindestens eine Funktionsbaugruppe (4-10) digitale Eingänge (22) und/oder Ausgänge (23) aufweist, und/oder
**dass** mindestens eine Funktionsbaugruppe (4-10) analoge Eingänge (24) und/oder Ausgänge (25) aufweist, und/oder
**dass** mindestens eine Funktionsbaugruppe (4-10) eine Kommunikationskarte aufweist, wobei die Kommunikationskarte insbesondere ausgebildet ist, mit einer RS232- und/oder RS485-Schnittstelle zu interagieren, und/oder
**dass** mindestens eine Funktionsbaugruppe (4-10) Steuermittel zur Ansteuerung von Heizelementen (28) aufweist, und/oder
dass mindestens eine Funktionsbaugruppe (4-10), insbesondere jede Funktionsbaugruppe (4-10) als Einschubkarte ausgebildet ist.

5. Steuerungssystem (1) nach einem der vorherigen Ansprüche, **dadurch gekennzeichnet, dass** jede Funktionsbaugruppe (4-10) eine Kommunikationsschnittstelle aufweist, welche zur Verbindung mit den Kommunikationsmitteln ausgebildet ist, um Steuersignale an die Hauptbaugruppe (3) zu senden und/oder Steuersignale von dieser zu empfangen, und/oder **dass** die Aufnahmeeinrichtung (2) als Rack, insbesondere als 19 Zoll-Rack nach EIA 310-D oder IEC 60297-3 oder nach DIN 41494 ausgebildet ist, und/oder
**dass** die Aufnahmen der Aufnahmeeinrichtung (2) als Einschübe ausgebildet sind, und/oder dass eine Aufnahme (11) zum Einsetzen der Hauptbaugruppe (3) und mehrere Aufnahmen (12) zum Einsetzen von Funktionsbaugruppen (4) ausgebildet sind, wobei, insbesondere, die Aufnahmen (12) für die Funktionsbaugruppen (4-10) identisch ausgebildet sind, und/oder wobei, insbesondere, die Aufnahme (11) für die Hauptbaugruppe (3) andere Abmessungen aufweist als die Aufnahmen (12) für die Funktionsbaugruppen (4-10).

6. Steuerungssystem (1) nach einem der vorherigen Ansprüche, **dadurch gekennzeichnet, dass** die Kommunikationsmittel in die Aufnahmeeinrichtung (2) integriert sind, wobei, insbesondere, die Kommunikationsmittel jeder Aufnahme (11, 12) zugeordnet mindestens einen Steckverbinder (14) umfassen, wobei, bevorzugt, die Steckverbinder (14) in die Aufnahmeeinrichtung (2) eingebaut sind und bevorzugt an einer Rückwand innenseitig angeordnet sind, sodass beim Einsetzen der Baugruppen (3, 4-10) in die Aufnahmeeinrichtung (2) die entsprechenden Kommunikationsschnittstellen der Baugruppen (3, 4-10) in Eingriff mit den Steckverbindern (14) kommen.

7. Steuerungssystem (1) nach einem der vorherigen Ansprüche, **dadurch gekennzeichnet, dass** die Kommunikationsmittel mindestens eine Busverbindung (15, 16), insbesondere zwei Busverbindungen (15, 16) aufweisen, die sich insbesondere zwischen der Aufnahme (11) der Hauptbaugruppe (3) und den Aufnahmen (12) der Funktionsbaugruppen (4-10) erstrecken.

8. Steuerungssystem (1) nach Anspruch 7, **dadurch gekennzeichnet, dass** eine Busverbindung (15) als Signalbus dient und sich von der Aufnahme (11) für die Hauptbaugruppe (3) zu den Aufnahmen (12) sämtlicher Funktionsbaugruppen (4-10) erstreckt, wobei, insbesondere, die Signalbus-Verbindung (15) als 8-bit-Busverbindung ausgebildet ist und/oder dazu ausgebildet ist, Steuer- und Regelbefehle von der Hauptbaugruppe (3) an die Funktionsbaugruppen (4-10) und umgekehrt zu übermitteln und/oder
**dass** eine Busverbindung als Steuerbus-Verbindung (16) ausgebildet ist, wobei, insbesondere, sich jeweils eine Steuerbus-Verbindung (16) von der Aufnahme (11) für die Hauptbaugruppe (3) zu jeder Aufnahme (12) für eine Funktionsbaugruppe (4-10) erstreckt, und/oder wobei, insbesondere, die Steuerbus-Verbindung (16) als 4-bit-Busverbindung ausgebildet ist, wobei, bevorzugt, ein Bit ausgebildet ist, eine Funktionsbaugruppe (4-10) dazu aufzufordern, ihre aktuellen Daten an die Hauptbaugruppe (3) zu senden, und/oder wobei ein Bit dazu ausgebildet ist, eine eingesetzte Funktionsbaugruppe (4-10) dazu aufzufordern, Daten von der Hauptbaugruppe (3) zu empfangen, und/oder wobei, bevorzugt, ein Bit dazu ausgebildet ist, derartige Anweisungen zu quittieren, und/oder wobei, bevorzugt, ein Bit ausgebildet ist, ein Fehlverhalten einer Funktionsbaugruppe (4-10) an die Hauptbaugruppe (3) zu übermitteln.

9. Steuerungssystem (1) nach einem der vorherigen Ansprüche, **dadurch gekennzeichnet, dass** die Aufnahmeeinrichtung (2) Stromversorgungsmittel aufweist, welche ausgebildet sind, eingesetzte Funktionsbaugruppen (4-10) mit Strom zu versorgen, wobei, insbesondere, die Stromversorgungsmittel eine Stromleitung (18) umfassen, welche von einer Aufnahme (11) für die Hauptbaugruppe (3) zu den Aufnahmen (12) für die Funktionsbaugruppen (4-10) verläuft.

10. Verfahren, insbesondere computergestütztes Verfahren zum Konfigurieren und/oder Betreiben eines Steuerungssystems (1), insbesondere zum Steuern von experimentellen Anordnungen, umfassend die folgenden Schritte:
- Bereitstellen eines modularen Steuerungssystems (1) nach einem der Ansprüche 1 bis 9;
- Einsetzen der Hauptbaugruppe (3) und der ausgewählten Funktionsbaugruppen (4-10) in entsprechende Aufnahmen (11, 12) der Aufnahmeeinrichtung (2);
- Einschalten der Stromversorgung;
- Selbstständiges Erkennen durch die Hauptbaugruppe (3), welche Funktionsbaugruppen (4-10) in die Aufnahmeeinrichtung (2) eingesetzt sind.

11. Verfahren nach Anspruch 10, **dadurch gekennzeichnet, dass** den einzelnen Eingängen (22, 24) und Ausgängen (23, 25) der Funktionsbaugruppe (4-10) selbständig Adressen zugewiesen werden, und/oder **dass** jeder Aufnahme (12) für eine Funktionsbaugruppe (4-10) eine eindeutige Kennung zugewiesen ist/ wird, und/oder
**dass** die Kommunikation zwischen den Funktionsbaugruppen (4-10) und der Hauptbaugruppe (3) ereignisbasiert erfolgt, und/oder
**dass** die Funktionsbaugruppen (4-10) eine eigene Rechnereinheit aufweisen und die jeweiligen Steuerungsaufgaben eigenständig ausführen.

12. Steuerungsanordnung umfassend mindestens zwei Steuerungssysteme nach einem der Ansprüche 1 bis 9.

13. Anordnung, insbesondere experimentelle Anordnung, umfassend
- ein modulares Steuerungssystem (1) nach einem der Ansprüche 1 bis 9 oder eine Steuerung seiner nach Anspruch 12;
- Komponenten (27-39), insbesondere experimentelle Komponenten, die mit dem modularen Steuerungssystem (1), insbesondere einer oder mehreren Funktionsbaugruppen (4-10) des Steuerungssystems (1) verbunden sind, sodass dass Steuerungssystem (1) die Komponenten der Anordnung steuern kann.

14. Computerprogrammprodukt, umfassend Befehle, die bewirken, dass das Steuerungssystem nach einem der Ansprüche 1 bis 9 und/oder die Anordnung nach Anspruch 13 das Verfahren nach Anspruch 10 oder 11 ausführt.

15. Computerlesbares Medium, auf dem das Computerprogrammprodukt nach Anspruch 14 gespeichert ist.
